# EUROPÄISCHE PATENTANMELDUNG

(11) **EP 4 549 905 A1**
(43) Veröffentlichungstag der Anmeldung: **07.05.2025**
(21) Anmeldenummer: 23207015.1
(22) Anmeldetag: 31.10.2023
(51) Int. Cl.: G01M 13/028, G01R 31/34

(54) **VERFAHREN UND SYSTEME ZUM ÜBERWACHEN VON ELEKTRISCHEN ROTATORISCHEN MASCHINEN**

(71) Anmelder: Siemens Aktiengesellschaft, 80333 München (DE)
(72) Erfinder: Brückel, Martin, 91052 Erlangen (DE); Pradhan, Pranita Rajan, 91058 Erlangen (DE)
(74) Vertreter: Siemens Patent Attorneys

(57) **Zusammenfassung**

Die Erfindung betrifft ein Verfahren zum Überwachen einer elektrischen rotatorischen Maschine (501), wobei
- einen Betrieb der Maschine betreffende Messdaten (507, 509) bereitgestellt werden (100),
- aus den Messdaten (507, 509) eine Abhängigkeit einer Drehzahl-Komponente der Schwingungsamplitude von der Drehzahl modelliert wird (104), um ein Schwingungsamplitudendrehzahlkomponente-Modell (201, 301, 401) zu erhalten,
- anhand des Schwingungsamplitudendrehzahlkomponente-Modells (201, 301, 401) der Schwingungsamplitude ein oder mehrere Drehzahlbereiche (202, 302a, 302b, 302c, 402) ermittelt werden (105), in welchen die Schwingungsamplitude ihren maximalen Wert (203, 303a, 303b, 303c, 403) erreicht,
- für die ermittelten Drehzahlbereiche (202, 302a, 302b, 302c, 402) das Verhalten der Schwingungsamplitude nach dem Schwingungsamplitudendrehzahlkomponente-Modell (201, 301, 401) mit einem Resonanzmodell verglichen wird, um festzustellen, ob in den entsprechenden Drehzahlbereichen (202, 302a, 302b, 302c, 402) eine Resonanz vorliegt,
- die ermittelten und eine Resonanz enthaltenden Drehzahlbereiche (202, 302a, 302b, 302c, 402) ausgegeben werden.

## Beschreibung

Die vorliegende Erfindung betrifft ein Verfahren und ein System zum Überwachen einer elektrischen rotatorischen Maschine, bei welchem einen Betrieb der Maschine betreffende Messdaten bereitgestellt werden.

Darüber hinaus betrifft die Erfindung ein Computerprogrammprodukt, welches Befehle umfasst, die, wenn sie durch einen Computer abgearbeitet werden, diesen dazu veranlassen, das vorgenannte Verfahren durchzuführen.

Außerdem betrifft die Erfindung eine Anordnung zum Überwachen einer elektrischen rotatorischen Maschine, wobei die Anordnung ein der Maschine zuordbares Messgerät und das vorgenannte System.

Obendrein betrifft die Erfindung ein Antriebssystem umfassend eine elektrische rotatorische Maschine und die genannte, der Maschine zugeordnete Anordnung.

Die Erfindung betrifft auch ein Simulationsprogrammprodukt zum Simulieren eines Betriebs einer elektrischen rotatorischen Maschine und zum Überwachen der Betriebssimulation.

Elektrische rotatorische Maschinen kommen bei vielen industriellen Anwendungen zum Einsatz. Bei Zustandsüberwachung der Maschinen ist eine der wichtigsten Messgrößen die Vibration, da diese, sofern mit ausreichend guter Messtechnik und in ausreichender Nähe zu den mechanischen Komponenten der Maschinen gemessen, einen guten Indikator für mögliche Fehler und Schadensfälle innerhalb der entsprechenden Komponenten darstellt.

Viele Geräte zur halb- oder zur vollautomatischen Zustandsüberwachung werten deshalb die Schwingungsdaten und das Schwingungsniveau aus, um Aussagen zum "Gesundheitszustand" der Maschine zu treffen. Ein grundsätzliches Problem stellt hierbei dar, dass die Schwingungsmessung von vielen externen Faktoren abhängen kann, besonders wenn nicht direkt an den mechanischen Komponenten (z.B. an dem Lagergehäuse der Maschine) gemessen wird. Besonders hat der Lastzustand der Maschine, der von der Applikation abhängt, in welcher die Maschine eingesetzt wird, einen wesentlichen Einfluss auf die Schwingungsamplitude, wie auch die Drehzahl. Eine häufige Ursache für ein erhöhtes Schwingungsniveau bei elektrischen rotatorischen Maschinen ist der Betrieb nahe einer mechanischen Resonanzfrequenz. Grundsätzlich ist bekannt, dass eine mechanische Resonanz dann auftritt, wenn das Schwingungsniveau einer Masse oder einer mechanischen Struktur sich nahe der jeweilen Eigenfrequenz verstärkt. Für eine rotierende Masse beziehungsweise ein rotierendes Element, wie es zum Beispiel in der elektrischen rotatorischen Maschine, beispielsweise in einem Motor oder in einer (rotierenden) Pumpe vorhanden ist, geschieht dies nahe der kritischen Drehzahl(en). In diesen Bereichen, also nahe der kritischen Drehzahl(en), beobachtet man einen Anstieg der Schwingungsamplitude, der zur Erhöhung der mechanischen Belastung der Komponenten der Maschine, beispielsweise des Motors oder der Pumpe, führt. In einem solchen Fall kann es zu einer Beeinträchtigung des Betriebs der Maschine durch zum Beispiel eine schnellere Ermüdung und/oder Schädigung von Lagern, das Entstehen einer Instabilität usw., bis hin zu einem verfrühten Ausfall der Maschine führen kann.

Ein möglicher Ansatz dem Problem zu begegnen, der insbesondere bei den umrichterbetriebenen elektrischen rotatorischen Maschinen, die mehrere mechanische Resonanzfrequenzen aufweisen können, zum Tragen kommen kann, ist die Steuerung des Umrichters derart zu "umprogrammieren", dass die erkannten kritischen Drehzahlen, bei welchen mechanische Resonanzen auftreten, vermieden werden. Zur Erkennung solcher kritischen Drehzahlen wird häufig bei der Inbetriebnahme der elektrischen rotatorischen Maschine eine Hochlauf-Messung durchgeführt, wobei der Antriebsstrang umfassend eine elektronische Steuereinheit (z.B. Umrichter) und eine elektrische rotatorische Maschine (z.B. Motor, Pumpe) innerhalb eines mehrminütigen Zeitfensters vom Stillstand bis zu einer vorgegebenen (z.B. der nominellen) Drehzahl beschleunigt wird, dabei alle im Betrieb auftretenden Drehzahlen durchläuft und während des gesamten Tests mit Hilfe eines beispielsweise hochaufgelösten Schwingungsmessgerätes die Schwingungsamplitude bezüglich der Drehzahl gemessen wird. Hieraus lassen sich dann die Resonanzfrequenzen bei der Inbetriebnahme erkennen und entsprechend bei der Programmierung der elektronischen Steuereinheit berücksichtigen, insbesondere vermeiden.

Die oben beschriebene Erkennung und Vermeidung von kritischen Drehzahlen, auch Resonanzdrehzahlen genannt, bei der Inbetriebnahme geht von einem über einen längeren Zeitraum weitgehend konstanten Resonanzverhalten der elektrischen rotatorischen Maschine im Betrieb aus. Aus Erfahrungen im Feld ist allerdings bekannt, dass sich Resonanzbereiche durchaus verschieben oder komplett ändern können, sodass von einem weitgehend konstanten Resonanzverhalten keine Rede sein kann. Die herkömmliche oben beschriebene Lösung würde verlangen, dass regelmäßig, insbesondere wenn eine Verschiebung und/oder Änderung eines oder mehrerer Resonanzbereiche festgestellt wird, eine neue Inbetriebnahme mit Resonanzermittlung mittels eines speziellen Messgeräts durchgeführt wird. Dies ist unpraktikabel, verursacht Zeitverluste und mit höherem Aufwand verbunden. Außerdem können sich auch innerhalb der elektronischen Steuereinheit eingestellte Werte verschieben und damit die Drehzahl in einen Resonanzbereich rutschen.

Somit liegt die Aufgabe der vorliegenden Erfindung darin, Verfahren und Systeme bereitzustellen, die den Echtzeitänderungen des Resonanzverhaltens der elektrischen rotatorischen Maschinen in einer einfachen Weise Rechnung tragen.

Die Aufgabe wird mit dem eingangs genannten Verfahren erfindungsgemäß dadurch gelöst, dass
- beispielsweise mit einer Auswerte-Komponente aus den Messdaten eine Abhängigkeit einer Drehzahl-Komponente der Schwingungsamplitude von der Drehzahl modelliert wird, um ein Schwingungsamplitudendrehzahlkomponente-Modell zu erhalten,
- anhand des Schwingungsamplitudendrehzahlkomponente-Modells der Schwingungsamplitude ein oder mehrere Drehzahlbereiche ermittelt werden, in welchen die Schwingungsamplitude ihren maximalen Wert erreicht,
- für die ermittelten Drehzahlbereiche vorzugsweise für jeden ermittelten Drehzahlbereich das Verhalten der Schwingungsamplitude nach dem Schwingungsamplitudendrehzahlkomponente-Modell mit einem Resonanzmodell verglichen wird, um festzustellen, ob in den entsprechenden Drehzahlbereichen eine Resonanz vorliegt,
- die ermittelten und eine vorzugsweise genau eine Resonanz enthaltenden Drehzahlbereiche ausgegeben werden.

Um festzustellen, ob in den entsprechenden Drehzahlbereichen eine Resonanz vorliegt, kann beispielsweise ein Ähnlichkeitsmaß, z.B. Korrelation, für die Ähnlichkeit des Verhaltens der Schwingungsamplitude in dem entsprechenden Drehzahlbereich und des Verhaltens der Schwingungsamplitude in dem Resonanzmodell verwendet werden.

Die Ausgabe kann beispielsweise über eine Ausgang-Schnittstelle beispielsweise direkt an einen Benutzer oder an einen computerimplementierten Assistenten erfolgen, welcher von dem Benutzer zum Steuern der Maschine verwendet wird und den Benutzer beim Produktionsprozess assistiert.

Damit lassen sich bereits bekannte und neu auftretende Resonanzbereiche erkennen und der Benutzer kann rechtzeitig gewarnt werden, wenn diese "Resonanzbetriebspunkte" häufiger im Betrieb vorkommen.

Bei einer Ausführungsform kann es vorgesehen sein, dass das Resonanzmodell aus bekannten Resonanzdaten verschiedener (verschiedene Größen, verschiedene Leistung, etc.) elektrischer rotatorischer Maschinen, d.h. die Abhängigkeiten der Drehzahl-Komponente der Schwingungsamplitude von der Drehzahl für die entsprechenden Maschinen, ein allgemeines Resonanzmodell, z.B. in Form einer Resonanzkurve für elektrische rotatorische Maschinen ermittelt wird.

Ein Vergleich mit einem Resonanzmodell es zweckmäßig, weil es sonst passieren kann, dass zwar ein Maximum ermittelt wird, dieses allerdings keiner Resonanz entspricht, d.h., durch kein exponentielles Wachstum der Schwingungsamplitude gekennzeichnet ist.

Bei einer Ausführungsform kann es vorgesehen sein, dass für einen oder mehrere der ermittelten Drehzahlbereiche, vorzugsweise für jeden ermittelten Drehzahlbereich, ermittelt wird, ob der entsprechende maximale Wert der Schwingungsamplitude in den jeweiligen Drehzahlbereichen einen vorbestimmten Wert übersteigt und der jeweilige Drehzahlbereich nur dann weiter berücksichtigt wird, wenn der maximale Wert der Schwingungsamplitude in diesem Bereich den vorbestimmten Wert übersteigt.

Bei einer Ausführungsform kann es vorgesehen sein, dass unterschiedliche ermittelte Drehzahlbereiche unterschiedliche Resonanzen enthalten.

Bei einer Ausführungsform kann es vorgesehen sein, dass für die ermittelten und eine Resonanz enthaltenden Drehzahlbereiche, vorzugsweise für jeden ermittelten und eine Resonanz enthaltenden Drehzahlbereich, zumindest eine, die entsprechende Resonanz kennzeichnende Charakteristik ermittelt und beispielsweise über eine weitere Schnittstelle ausgegeben wird.

Für jede erkannte Resonanz kann zumindest eine Charakteristik dieser Resonanz an den Benutzer der Maschine kommuniziert werden. Dabei können als KPI beispielsweise die Anzahl der Betriebsstunden, die in dem Resonanzbereich verbracht werden; die Amplitude der erkannten Resonanz; den Wert, der beschreibt, wie zuverlässig es bestimmt wurde, dass in dem entsprechenden Drehzahlbereich eine Resonanz vorliegt, usw. angeben. Der Benutzer sieht dann, wie schädigend die Resonanz ist und eine oder mehrere Gegenmaßnahmen einleiten, z.B. die Resonanz nicht anfahren und/oder die entsprechende mechanische Komponente kontrollieren.

Bei einer Ausführungsform kann es vorgesehen sein, dass die elektrische rotatorische Maschine entsprechend den ermittelten und eine Resonanz enthaltenden Drehzahlbereichen gesteuert wird, um diese Resonanzdrehzahlbereiche zu vermeiden.

Bei einer Ausführungsform kann es vorgesehen sein, dass die Messdaten Daten über das Drehmoment und die Schwingungsamplitude und vorzugsweise über die Drehzahl umfassen.

Bei einer Ausführungsform kann es vorgesehen sein, dass, um das Schwingungsamplitudendrehzahlkomponente-Modell zu erhalten,
- aus den Messdaten ein Drehmoment-Schwingungsamplitude-Modell der Maschine ermittelt wird, welches abhängig von einem anliegenden Drehmoment eine Schwingungsamplitude modelliert,
- mittels des Drehmoment-Schwingungsamplitude-Modells aus den Messdaten die Abhängigkeit der Drehzahl-Komponente der Schwingungsamplitude von der Drehzahl modelliert (z.B. mittels Best-Fit, o.Ä.) wird.

Dabei kann es mit Vorteil vorgesehen sein, dass das Modellieren der Abhängigkeit der Drehzahl-Komponente der Schwingungsamplitude von der Drehzahl mittels des Drehmoment-Schwingungsamplitude-Modells ein Ermitteln der Werte der Drehzahl-Komponente und beispielsweise der Drehmoment-Komponente der Schwingungsamplitude aus den Messdaten für vorzugsweise alle Datenpunkte umfasst. Das Ermitteln kann für alle drei räumlichen Komponenten der Schwingung gemacht werden.

Bei einer Ausführungsform kann es vorgesehen sein, dass die Messdaten durch eine im Betrieb der Maschine über einen Zeitraum durchgeführte Messung gesammelt wurden, und vorzugsweise bei der Messung zumindest zwei räumliche Komponenten der Schwingungsamplitude gemessen wurden.

Bei einer Ausführungsform kann es vorgesehen sein, dass die Messung mit einem an einem Gehäuse der Maschine drahtlos angebrachten (drahtlos bezieht sich auf das Anbringen des Geräts, es sind keine Kabelverbindungen zwischen dem Gerät und der Maschine vorhanden) Messgerät erfolgt.

Die Aufgabe wird außerdem mit einem eingangs genannten System zum Überwachen einer elektrischen rotatorischen Maschine, wobei das System eine Eingang-Schnittstelle, eine Ausgang-Schnittstelle, einen Prozessor und einen mit dem Prozessor verbundenen Speicher umfasst, wobei der Speicher dazu eingerichtet ist, eine oder mehrere durch den Prozessor ausführbaren Komponenten zu tragen, wobei der Prozessor dazu eingerichtet ist, die eine oder mehr auf dem Speicher zur Verfügung gestellten Komponenten auszuführen, erfindungsgemäß dadurch gelöst, dass
- die Eingang-Schnittstelle dazu eingerichtet ist, einen Betrieb der Maschine betreffende Messdaten zu empfangen,
- der Speicher eine Auswerte-Komponente umfasst, die dazu konfiguriert ist:
   * aus den Messdaten eine Abhängigkeit einer Drehzahl-Komponente der Schwingungsamplitude von der Drehzahl zu modellieren, um ein Schwingungsamplitudendrehzahlkomponente-Modell zu erhalten,
   * anhand des Schwingungsamplitudendrehzahlkomponente-Modells der Schwingungsamplitude einen oder mehrere Drehzahlbereiche zu ermitteln, in welchen die Schwingungsamplitude ihren maximalen Wert *(im funktionalen Sinne, mathematisch)* erreicht,
   * aus bekannten Resonanzdaten unterschiedlicher elektrischer rotatorischer Maschinen ein Resonanzmodell für elektrische rotatorische Maschinen zu ermitteln,
   * für die ermittelten Drehzahlbereiche anhand des Drehzahl-Komponente-Modells der Schwingungsamplitude und des Resonanzmodells festzustellen, ob in den entsprechenden Drehzahlbereichen eine Resonanz vorliegt,
- die Ausgang-Schnittstelle dazu eingerichtet ist, die ermittelten und eine Resonanz enthaltenden Drehzahlbereiche auszugeben.

Die Aufgabe wird außerdem mit einer eingangs genannten Anordnung erfindungsgemäß dadurch gelöst, dass
- das Messgerät dazu eingerichtet ist, einen Betrieb der Maschine betreffende Messdaten zu sammeln und die Messdaten an das vorgenannte System vorzugsweise drahtlos zu senden.

Darüber hinaus wird die Aufgabe mit einem eingangs genannten Simulationsprogrammprodukt erfindungsgemäß dadurch gelöst, dass
- das Simulationsprogrammprodukt einen digitalen Zwilling der Maschine umfasst, welcher ein statisches Modell und ein elektromechanisches Modell der Maschine aufweist, wobei der digitale Zwilling der Maschine ermöglicht, durch Simulation des Betriebs der Maschine Simulationsmessdaten zu erzeugen, und insbesondere während der Betriebssimulation Vibrationen der Maschine zu simulieren,
- das Simulationsprogrammprodukt eine Auswerte-Komponente und dazu konfiguriert ist, die Simulationsmessdaten der Auswerte-Komponente zuzuführen, wobei
- die Auswerte-Komponente dazu konfiguriert ist:
   * aus den Simulationsmessdaten eine Abhängigkeit einer Drehzahl-Komponente der Schwingungsamplitude von der Drehzahl zu modellieren, um ein Schwingungsamplitudendrehzahlkomponente-Modell zu erhalten,
   * anhand des Schwingungsamplitudendrehzahlkomponente-Modells der Schwingungsamplitude einen oder mehrere Simulation-Drehzahlbereiche zu ermitteln, in welchen die Schwingungsamplitude ihren maximalen Wert erreicht,
   * aus bekannten Resonanzdaten unterschiedlicher elektrischer rotatorischer Maschinen ein Resonanzmodell für elektrische rotatorische Maschinen zu ermitteln,
   * für die ermittelten Drehzahlbereiche anhand des Drehzahl-Komponente-Modells der Schwingungsamplitude und des Resonanzmodells festzustellen, ob in den entsprechenden Simulation-Drehzahlbereichen eine Resonanz vorliegt,
- das Simulationsprogrammprodukt dazu konfiguriert ist, die ermittelten und eine Resonanz enthaltenden Simulation-Drehzahlbereiche auszugeben.

Durch eine solche Vorabsimulation können beispielsweise die möglichen echten Schadensfälle an der Maschine vermieden werden.

Im Folgenden wird die Erfindung anhand der in den Figuren dargestellten Ausführungsbeispiele näher beschrieben und erläutert. Es zeigen:
- FIG 1: ein Flussdiagramm eines Überwachungsverfahrens für eine elektrische rotatorische Maschine,
- FIG 2 bis 4: ausgegebene mittels Verfahrens der FIG 1 ermittelte Drehzahlbereiche, und
- FIG 5: eine Produktionsumgebung, in der hier offenbarte Verfahren und Systeme implementiert werden können.

In den Ausführungsbeispielen und Figuren können gleiche oder gleichwirkende Elemente jeweils mit den gleichen Bezugszeichen versehen sein. Die dargestellten Elemente und deren Grö-ßenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein.

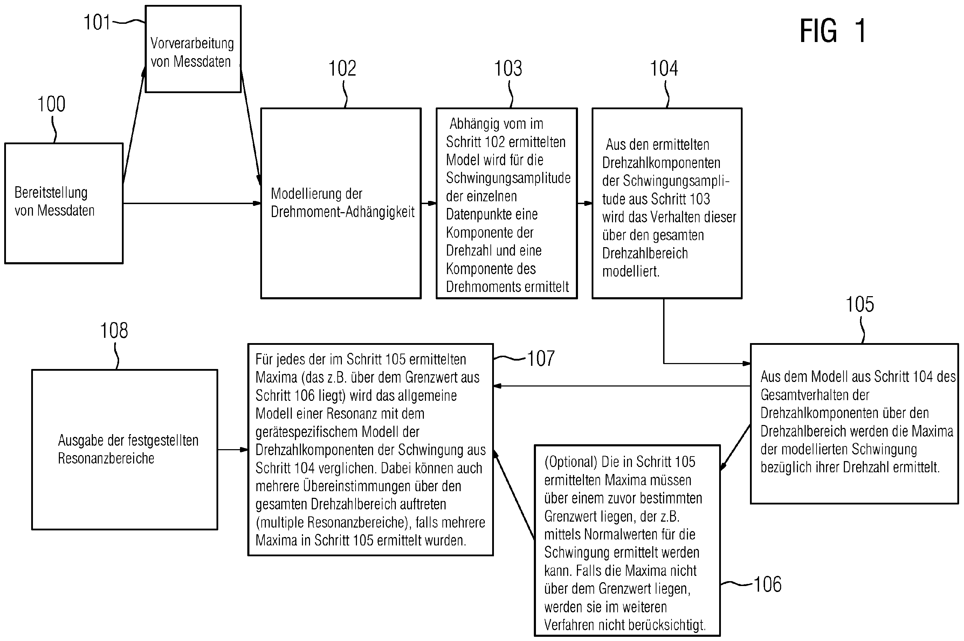

FIG 1 zeigt einen beispielhaften Ablaufdiagramm eines Verfahrens zum Überwachen einer elektrischen rotatorischen Maschine.

In einem ersten Schritt 100 werden Messdaten bereitgestellt, beispielsweise empfangen, die den Betrieb der Maschine charakterisieren.

Die Messdaten umfassen vorzugsweise Daten über das Drehmoment und die Schwingungsamplitude und vorzugsweise über die Drehzahl der Maschine.

Die Messdaten sind vorzugsweise durch eine im Betrieb der Maschine über einen Zeitraum durchgeführte Messung gesammelt wurden. Dabei handelt es sich um eine Lernphase des Verfahrens, in welcher die Maschine kennengelernt wird. Beispielsweise kann in einem Zeitraum von mehreren Monaten, z.B. von sechs Monaten eine Messung der Schwingung und des Lastzustandes (und vorzugsweise des Drehmoments) der Maschine erfolgen, wobei pro mehrere Minuten, z.B. pro fünf Minuten, jeweils eine Messung, also ein Datenpunkt ausreichend sein kann.

Die Messung kann derart erfolgen, dass dabei beispielsweise zumindest zwei, vorzugsweise drei räumliche Komponenten der Schwingungsamplitude gemessen wurden.

Die Messdaten können beispielsweise in Form von nicht synchronen Rohdaten, insbesondere Zeitreihen bereitgestellt werden. In einem solchen Fall kann es zweckdienlich sein, die bereitgestellten Daten einer Vorverarbeitung 101 zu unterziehen. Diese kann je nach bereitgestellten Messdaten beispielsweise vorsehen, dass die beispielsweise nichtsynchronisierten Daten in den Messdaten synchronisiert werden, indem sie beispielsweise zu einer Zeitreihe mit gleichen Zeitstempeln zusammengefasst werden, und/oder Aus-Zustände der Maschine, d.h., die Zustände, bei welchen die Maschine nicht in Betrieb war, herausgefiltert werden.

Nachdem die Messdaten bereitgestellt 100 und vorzugsweise vorverarbeitet 101 wurden, wird aus den Messdaten eine Abhängigkeit einer Drehzahl-Komponente der Schwingungsamplitude von der Drehzahl modelliert, um ein Schwingungsamplitude-Drehzahlkomponente-Modell zu erhalten.

Hierfür kann beispielsweise zunächst eine Modellierung 102 einer Drehmoment-Abhängigkeit für die Maschine stattfinden. Dabei werden aus den Messdaten ein Modell ermittelt, welches abhängig von einem an der Maschine anliegenden Drehmoment ihre Schwingungsamplitude modelliert (z.B. Gauß-Prozess). Hierdurch erhält man ein Drehmoment-Schwingungsamplitude-Modell der Maschine.

Das Drehmoment-Schwingungsamplitude-Modell kann nun dazu verwendet werden, um aus den Messdaten die Abhängigkeit der Drehzahl-Komponente der Schwingungsamplitude von der Drehzahl, beispielsweise mittels einer Best-Fit-Methode zu modellieren.

Hierzu können zunächst Werte der Drehzahl-Komponente und beispielsweise der Drehmoment-Komponente der Schwingungsamplitude aus den Messdaten für vorzugsweise alle Datenpunkte ermittelt werden 103. Dies kann beispielsweise für alle drei räumlichen Komponenten der Schwingung durchgeführt werden.

Es sei betont, dass die Ermittlung der Werte der Drehmoment-Komponente optional ist, weil es Applikationen gibt, bei welchen die Drehmoment-Komponente immer gleich Null ist und von vornherein vernachlässigt werden kann. Man denke dabei z.B. an einen Lüfter, bei dem Drehmoment-Drehzahl-Kennlinie vorliegt, d.h. das Drehmoment kann eindeutig anhand der Drehzahl berechnet werden und umgekehrt, wodurch die Drehmoment-Komponente der Schwingungsamplitude gleich Null ist.

Anschließend kann aus den ermittelten Werten der Drehzahl-Komponente der Schwingungsamplitude das Verhalten dieser über den aus den Messdaten hervorgehenden Drehzahlbereich modelliert werden 104, wodurch das vorgenannte Schwingungsamplitude-Drehzahlkomponente-Modell erhalten wird.

Anhand des Schwingungsamplitudendrehzahlkomponente-Modells, welches das Verhalten der Schwingungsamplitude abhängig von der Drehzahl im gemessenen Drehzahlbereich beschreibt, werden ein oder mehrere Drehzahlbereiche ermittelt 105, in welchen die Schwingungsamplitude ihren maximalen Wert erreicht. Dabei wird auf maximale Werte im funktionalen Sinne, mathematisch abgestellt. Mit anderen Worten werden aus dem Schwingungsamplitudendrehzahlkomponente-Modell des Gesamtverhaltens der Drehzahlkomponente der Schwingungsamplitude Maxima der modellierten Schwingung bezüglich ihrer Drehzahl ermittelt. Dabei können mehrere Maxima festgestellt werden. Die so ermittelten Drehzahlbereiche stellen gute Kandidaten für die Resonanzbereiche dar, die, wie bereits dargelegt, von großer Relevanz für den Benutzer der Maschine sind.

Das Verfahren kann beschleunigt werden, wenn nachfolgend nicht alle der ermittelten Drehzahlbereiche berücksichtigt werden. Dies kann mittels einer entsprechenden optionalen Filterung 106 erreicht werden.

Die Filterung 106 kann beispielsweise vorsehen, dass für einen oder mehrere der ermittelten Drehzahlbereiche, vorzugsweise für jeden ermittelten Drehzahlbereich, ermittelt wird, ob der entsprechende maximale Wert der Schwingungsamplitude in den jeweiligen Drehzahlbereichen einen vorbestimmten Wert übersteigt und der jeweilige Drehzahlbereich nur dann weiter berücksichtigt wird, wenn der maximale Wert der Schwingungsamplitude in diesem Bereich den vorbestimmten Wert übersteigt.

Mit anderen Worten kann geprüft werden 106, ob die in Schritt 105 ermittelten Maxima über einem zuvor bestimmten Grenzwert liegen, der beispielsweise aus Normalwerten für die Schwingung ermittelt werden kann. Beispielsweise kann hierzu die Norm ISO 10816 einschlägig sein. Falls die Maxima nicht über dem Grenzwert liegen, werden sie im weiteren Verfahren nicht mehr berücksichtigt.

Um festzustellen, ob in den entsprechenden Drehzahlbereichen tatsächlich eine Resonanz vorliegt, wird im jeweiligen Drehzahlbereich, vorzugsweise in jedem ermittelten Drehzahlbereich, das Verhalten der Schwingungsamplitude nach dem Drehzahl-Komponente-Modell der Schwingungsamplitude (oder nach dem Schwingungsamplitudendrehzahlkomponente-Modell) mit einem Verhalten der Schwingungsamplitude gemäß einem vorbestimmten Resonanzmodell verglichen 107. Hierbei kann beispielsweise ermittelt werden, wie ähnlich das Schwingungsverhalten der Maschine in dem jeweiligen ermittelten Drehzahlbereich einem Resonanzverhalten ist. Hierzu kann ein Ähnlichkeitsmaß, z.B. entsprechende Korrelationskoeffizienten oder ein anderes Ähnlichkeitsmaß, z.B. beispielsweise Minkowski Metriken oder Dynamic Time Warping Metrik, herangezogen werden.

Mit anderen Worten kann für jedes der in Schritt 105 ermittelten Maxima, das vorzugsweise über dem Grenzwert aus Schritt 106 liegt, ein allgemeines Modell einer Resonanz mit dem (maschinenspezifischen) Modell der Drehzahlkomponenten der Schwingung aus Schritt 104 verglichen werden. Dabei können mehrere Übereinstimmungen über den gesamten gemessenen Drehzahlbereich auftreten, falls multiple Resonanzbereiche in Schritt 105 ermittelt werden.

Vorzugsweise enthalten unterschiedliche ermittelte Drehzahlbereiche unterschiedliche Resonanzen.

Dieser Vergleich ist zweckdienlich, weil es sonst passieren kann, dass ein Maximum ermittelt wird, welches keine Resonanz ist, d.h., durch kein exponentielles Wachstum der Schwingungsamplitude gekennzeichnet ist.

Das vorbestimmte Resonanzmodell kann beispielsweise aus bekannten Resonanzdaten verschiedener elektrischer rotatorischer Maschinen abgeleitet werden, wobei verschiedene Maschinen sich in Größen, Leistung, usw. unterscheiden können. Aus diesen historischen Resonanzdaten können die Abhängigkeiten der Drehzahl-Komponente der Schwingungsamplitude von der Drehzahl für die jeweiligen Maschinen ermittelt und darauf basierend ein generelles Resonanzmodell, beispielsweise in Form einer Resonanzkurve für elektrische rotatorische Maschinen erstellt werden.

Mit anderen Worten kann aus bekannten Resonanzdaten verschiedener Maschinen ein allgemeines Resonanzverhalten, beispielsweise eine Resonanzkurve, der Drehzahlkomponenten der Schwingungsamplitude modelliert werden. Hierzu kann beispielsweise Lorenz-Oszillator-Modell verwendet werden.

Die ermittelten und eine, vorzugsweise genau eine, Resonanz enthaltenden Drehzahlbereiche werden ausgegeben 108.

Die Ausgabe kann beispielsweise an einen Benutzer oder an einen computerimplementierten Assistenten erfolgen. Der Assistent ist beispielsweise in einem Datenverarbeitungssystem enthalten, welches von dem Benutzer zum Steuern der Maschine verwendet werden kann und den Benutzer beim Produktionsprozess assistiert.

Hilfsweise kann es vorgesehen sein, dass die elektrische rotatorische Maschine entsprechend den ermittelten und eine Resonanz enthaltenden Drehzahlbereichen gesteuert wird, um diese Resonanzdrehzahlbereiche im Betrieb zu vermeiden.

Es kann mit Vorteil vorgesehen sein, dass für die ermittelten und eine Resonanz enthaltenden Drehzahlbereiche vorzugsweise für jeden ermittelten und eine Resonanz enthaltenden Drehzahlbereich zumindest eine, die entsprechende Resonanz kennzeichnende Charakteristik ermittelt ausgegeben wird.

Vorteilhaft ist dabei, dass für vorzugsweise jede erkannte Resonanz zumindest eine Charakteristik dieser Resonanz an den Benutzer kommuniziert werden kann. Die Charakteristik kann beispielsweise eine oder mehrere der folgenden Größen - sogenannte KPIs - umfassen: die Ähnlichkeit der Übereinstimmung aus Schritt 107, d.h. die Ähnlichkeit des Resonanzmodells mit dem Verhalten der Drehzahl-Komponente der Schwingungsamplitude der Maschine; die Anzahl der in der Resonanz verbrachten Betriebsstunden; die Amplitude der erkannten Resonanz; der Wert, der beschreibt, wie zuverlässig es bestimmt wurde, dass in dem entsprechenden Drehzahlbereich eine Resonanz vorliegt, usw. Darüber hinaus können eine oder mehrere entsprechende Gegenmaßnahmen vorgeschlagen werden, wie z.B. die vorgenannte Vermeidung der Resonanzbereiche und/oder eine frühere Wartung und/oder Kontrolle einer oder mehr der mechanischen Komponenten, wie z.B. Lager der Maschine, usw.

Für den Benutzer ist dann sofort ersichtlich, wie schädigend die Resonanz für die Maschine ist und wie stark die Resonanz den Betrieb beeinträchtigt.

Anhand dieser zuverlässig vorliegenden Information wird der Benutzer kontinuierlich durch den Prozess geleitet und assistiert und kann jederzeit eine oder mehrere der vorgenannten Gegenmaßnahmen einleiten (Resonanz nicht anfahren, die entsprechende mechanische Komponente kontrollieren).

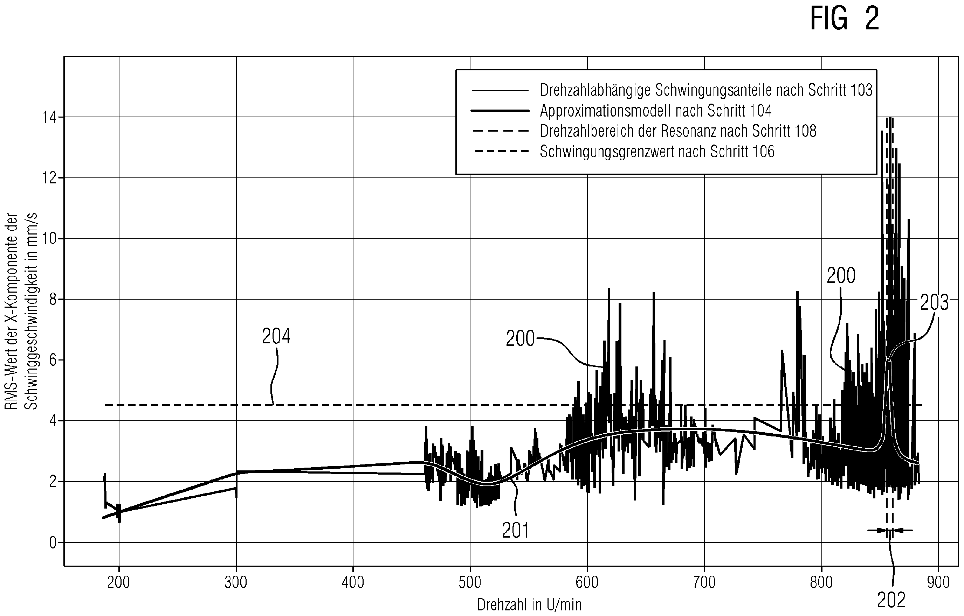

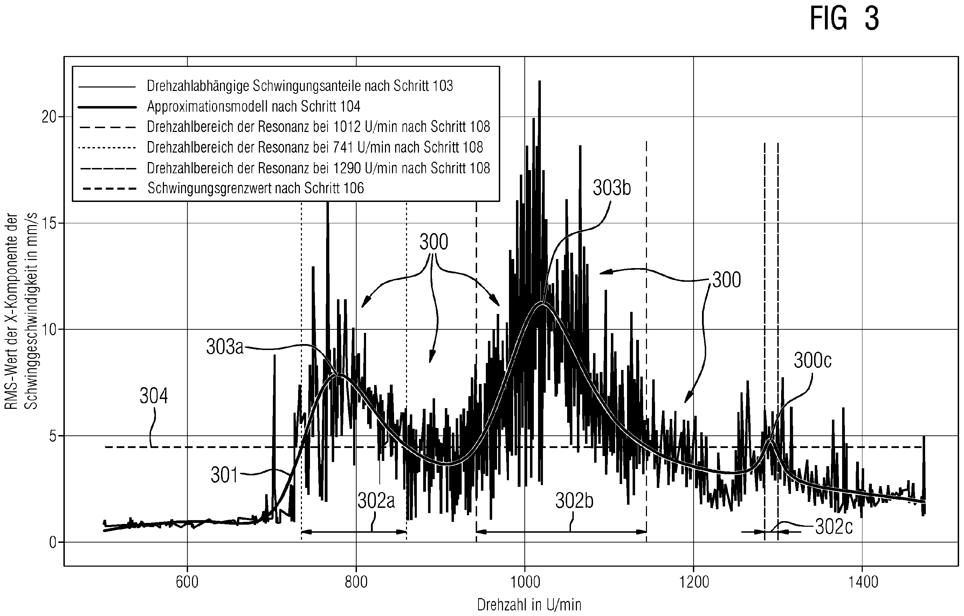

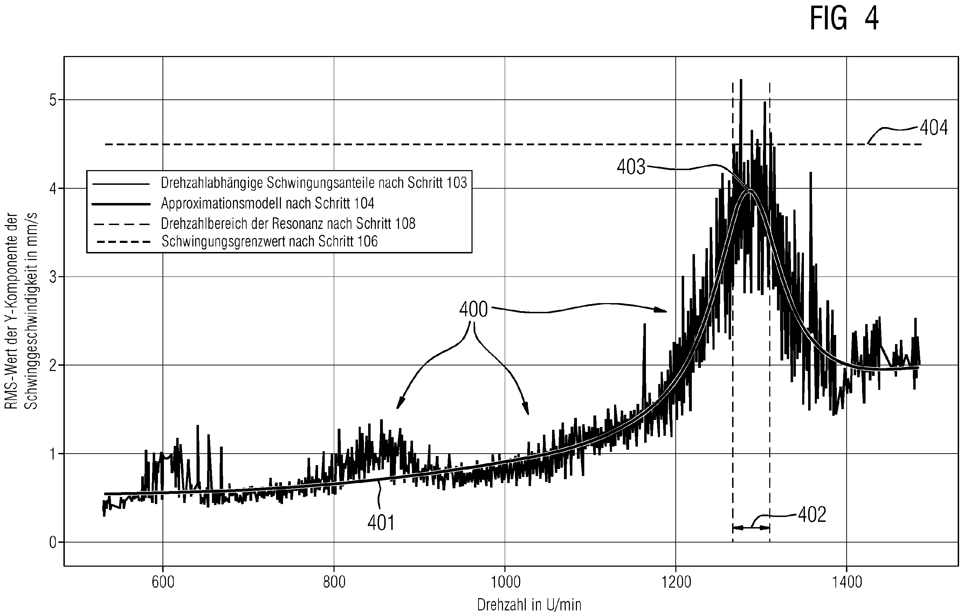

FIG 2 bis FIG 4 zeigen allesamt mögliche beispielhafte Ausgaben der ermittelten Resonanzdrehzahlbereiche an einen Benutzer. Gezeigt ist jeweils ein Effektivwert (in Englisch: RMS, root mean square) einer räumlichen Komponente der Schwinggeschwindigkeit in Millimeter pro Sekunde als Funktion der Drehzahl Umdrehungen pro Minute. In FIG 2 und FIG 3 ist die X-Komponente der Schwinggeschwindigkeit und in FIG 4 ist die Y-Komponente der Schwinggeschwindigkeit abgebildet.

Der in der jeweiligen Figur gezeigte oszillierende Anteil 200, 300, 400 repräsentiert die entsprechenden drehzahlabhängigen Schwingungsanteile, die beispielsweise in Schritt 103 des vorgenannten Verfahrens ermittelt werden.

Die durchzogene Linie 201, 301, und 401 ist das Approximationsmodell, welches das Verhalten der jeweiligen räumlichen Komponente der Drehzahlkomponente der Schwingung in dem gemessenen Drehzahlbereich darstellt. Mit anderen Worten ist das nach Schritt 104 ermittelte Schwingungsamplitude-Drehzahlkomponente-Modell in Form einer Kurve für die jeweilige räumliche Komponente der Schwingung.

FIG 2 zeigt lediglich einen Drehzahlbereich 202 mit einem Maximum 203 des Schwingungsamplitude-Drehzahlkomponente-Modells 201, welcher nach einem Vergleich mit einem Resonanzmodell als ein Resonanzbereich erkannt wird.

Darüber hinaus liegt der Wert des Maximums 203 oberhalb eines beispielsweise in einer Norm definierten Schwingungsgrenzwertes 204, der beispielsweise in Schritt 106 definiert wird. D.h., der Resonanzbereich 202 wird als "kritisch" erkannt und auch als solcher gemeldet.

Beim Drehzahlkomponenten-Model der Schwingungsamplitude 301 der FIG 3 werden drei Drehzahlbereiche 302a, 302b, und 302c mit den entsprechenden Maxima 303a, 303b, und 303c erkannt. Alle drei Maxima 303a, 303b, und 303c liegen über dem vorzugsweise normierten Schwingungsgrenzwert 304, sodass jeder Resonanzdrehzahlbereich 302a, 302b, und 302c als "kritisch" einzustufen ist.

Für die in FIG 4 gezeigte y-Komponente der Schwingungsgeschwindigkeit wird ein Drehzahlbereich 402 mit einem entsprechenden Maximum 403 ermittelt. Im Gegensatz zu in FIG 2 oder 3 gezeigten Situation liegt das Maximum 403 unterhalb des in der Norm definierten Schwingungsgrenzwertes 404, sodass der Drehzahlbereich 402 als "nicht kritisch" einzuordnen ist.

In jedem Fall erkennt der Benutzer sofort an den ausgegebenen und als solche gekennzeichneten kritischen Drehzahlbereichen jene Fälle, welche Gegenmaßnahmen erfordern und welche nicht. Beispielsweise beim Vorliegen eines nicht kritischen Resonanzbereichs, wie in FIG 4, sind keine weiteren Maßnahmen erforderlich und der Betrieb der Maschine kann ohne Änderungen fortgeführt werden.

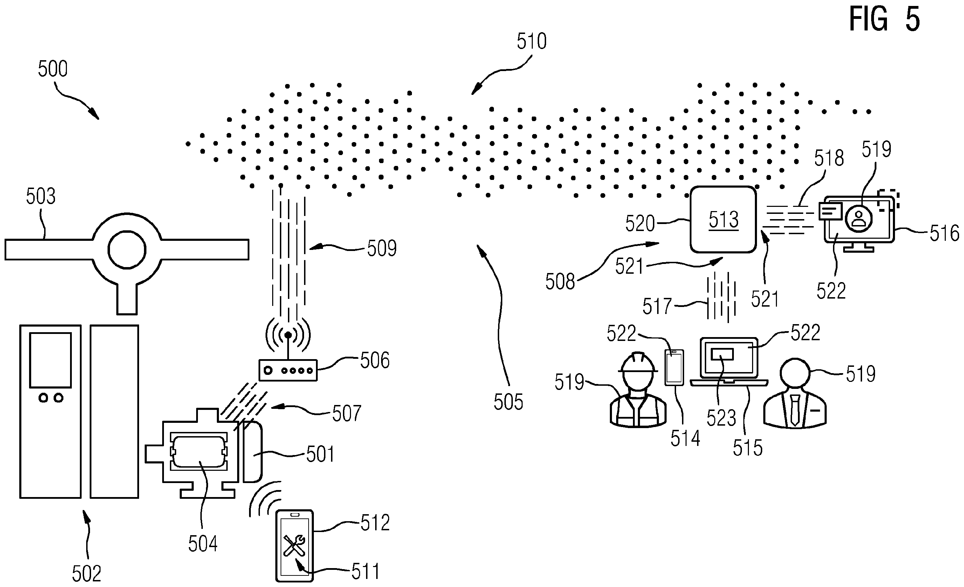

FIG 5 zeigt eine Produktionsumgebung, in welcher das hierin offenbarte Überwachungsverfahren implementiert werden kann.

Die Produktionsumgebung umfasst eine elektrische rotatorische Maschine, die als ein Elektromotor 501 ausgebildet ist. Der Elektromotor 501 wird beispielsweise von einer elektronischen Steuereinheit betrieben, die beispielsweise als ein Umrichter 502 ausgebildet ist. Der Umrichter 502 ist ans Netz 503 angeschlossen, um den Elektromotor 501 mit Strom und Spannung zu versorgen.

Es versteht sich, dass die Produktionsumgebung üblicherweise eine Mehrzahl von derartigen Maschinen und entsprechenden Steuereinheiten aufweist.

Um das Betriebsverhalten des Motors 501 zu überwachen, ist ein Messgerät 504 vorgesehen. Das Messgerät 504 ist an dem Gehäuse außen an der Maschine 501 angebracht. Das Messgerät 504 ist derart ausgebildet und konfiguriert, dass es keiner Draht- beziehungsweise Kabelverbindungen mit der Maschine 501 benötigt, um die Messung durchzuführen. Beispielsweise erfasst das Messgerät 504 Schwingungen des Elektromotors 501. Die Schwingung beziehungsweise die Schwingungsamplitude ist grundsätzlich eine Funktion von Drehzahl und dem Drehmoment. Es kann darüber hinaus vorgesehen sein, dass das Messgerät 504 weitere physikalische Größen, wie beispielsweise Streumagnetfelder erfassen kann. Darüber hinaus kann vorgesehen sein, dass das Messgerät 504 die gesammelten Messdaten 507 vorverarbeitet.

Um Analyse und Auswertung von großen Datenmengen aus der Produktionsumgebung 500 zu ermöglichen, ist das Messgerät 504 vorteilhafterweise an eine übergeordnete IT-Infrastruktur 505 angebunden. Die IT-Infrastruktur 505 weist eine oder mehr Datentransferkomponenten 506, wie beispielsweise Proxies, Gateways und dergleichen, die eingerichtet und konfiguriert sind, die gesammelten und möglicherweise vorverarbeiteten Messdaten 507 von dem Messgerät 504 zu empfangen und an das entsprechende Datenverarbeitungssystem 508 zu übermitteln. Die Daten 509 können zunächst beispielsweise drahtlos, beispielsweise über WiFi an ein Netzwerk 510, beispielsweise an eine Cloud-Infrastruktur weitergeleitet und von dort an das Datenverarbeitungssystem 508 übermittelt werden.

Die Anbindung des Messgeräts 504 an die IT-Infrastruktur 505 kann beispielsweise mittels einer dedizierten Applikation 511, die auf einem tragbaren Computergerät 512, wie beispielsweise Smartphone, Laptop, Notebook oder ähnlichem ausgeführt wird. Dabei wird das Computergerät 512 mit dem Messgerät 504 vorzugsweise drahtlos, beispielsweise über Bluetooth verbunden, um die Anbindung Applikation 511 auszuführen und das Messgerät 504 an die IT-Infrastruktur 505 anzubinden.

Das Datenverarbeitungssystem 508 kann eine Datenanalyse-Applikation 513 aufweisen. Die Datenanalyse-Applikation 513 kann in der Cloud-Infrastruktur 510 residieren und dort ausgeführt werden. Des Weiteren kann das Datenverarbeitungssystem 508 eine oder mehrere beispielsweise lokale Recheneinheiten 514, 515, 516 umfassen, die eine entsprechende Verbindung 517, 518 zu der Cloud-Infrastruktur 510 aufbauen können, um auf die Datenanalyse-Applikation 513 zuzugreifen und eine entsprechende Datenanalyse durchzuführen.

Die Datenanalyse-Applikation 513 kann grundsätzlich einen oder mehrere Benutzer 519 beim Produktionsprozess assistieren. Je nach Fragestellung kann das Datenanalyse-Applikation 513 den einen oder mehrere Benutzer 519 bei der Überwachung des Motors 501 zwecks Wartung beziehungsweise Serviceoptimierung und/oder zwecks der Implementierung von neuen Kunden Businessmodellen und/oder zwecks der prädiktiven Instandhaltung begleitend unterstützen.

Mit anderen Worten ist die Datenanalyse-Applikation 513 ein computerimplementierter Assistent der Benutzer des einen oder mehrerer Elektromotoren 501 in der Produktionsumgebung 500.

Die Datenanalyse-Applikation 513 kann beispielsweise Befehle enthalten, welche beim Ausführen durch das Datenverarbeitungssystem 508 dieses dazu veranlassen, die in Bezug auf die Figuren 1 bis 4 beschriebenen Verfahrensschritte durchzuführen.

Die Datenanalyse-Applikation 513 kann eine oder mehrere Eingang- 520 und Ausgang-Schnittstellen 521 umfassen.

Die Eingang-Schnittstelle 520 kann dazu konfiguriert sein, um die gesammelten Messdaten 507, 509 von der Cloud-Infrastruktur 510 zu empfangen.

Die Ausgang-Schnittstellen 521 können dazu konfiguriert sein, Ergebnisse der durch die Datenanalyse-Applikation 513 erfolgten Analyse an eine oder mehrere Visualisierungsvorrichtungen 522. Die jeweilige Visualisierungsvorrichtung 522 kann beispielsweise als ein Teil der entsprechenden Recheneinheit 514 bis 516 ausgebildet sein.

In der Datenanalyse-Applikation 513 ist eine Auswerte-Komponente (hier nicht gezeigt) implementiert, die dazu konfiguriert ist:
- aus den Messdaten 507, 509 eine Abhängigkeit einer Drehzahl-Komponente der Schwingungsamplitude von der Drehzahl zu modellieren, um ein Schwingungsamplitudendrehzahlkomponente-Modell zu erhalten,
- anhand des Schwingungsamplitudendrehzahlkomponente-Modells der Schwingungsamplitude einen oder mehrere Drehzahlbereiche zu ermitteln, in welchen die Schwingungsamplitude ihren maximalen Wert erreicht,
- aus bekannten Resonanzdaten unterschiedlicher elektrischer rotatorischer Maschinen ein Resonanzmodell für elektrische rotatorische Maschinen zu ermitteln, und
- für die ermittelten Drehzahlbereiche anhand des Drehzahl-Komponente-Modells der Schwingungsamplitude und des Resonanzmodells festzustellen, ob in den entsprechenden Drehzahlbereichen eine Resonanz vorliegt.

Die ermittelten und eine Resonanz enthaltenden Drehzahlbereiche können beispielsweise an einer oder mehreren Visualisierungsvorrichtungen 522 visualisiert und somit an einen Benutzer ausgegeben werden.

Die für die Ermittlung des Resonanzmodells erforderlichen Resonanzdaten können in der Cloud-Infrastruktur 510 vorliegen und für das Datenverarbeitungssystem 508 zugreifbar sein, wobei das Datenverarbeitungssystem 508 das Resonanzmodell bilden kann. Alternativ oder zusätzlich können die Resonanzdaten den Datenverarbeitungssystem 508 von einer anderen, hier nicht gezeigten Datenbank zur Verfügung gestellt werden, wobei die Datenbank nicht ein Teil der Cloud-Infrastruktur 510 sein muss. Insbesondere kann vorgesehen sein, dass die Resonanzdaten der Datenanalyse-Applikation 513 zugeführt werden und die Datenanalyse-Applikation 513 das Resonanzmodell bildet.

Um die Benutzer insbesondere bei Entwicklung beziehungsweise Engineering der Produktionsumgebung zu unterstützen, kann es vorgesehen sein, dass das Datenverarbeitungssystem 508 ein Simulationsprogramm 523 umfasst, welches zum Simulieren des Betriebsverhaltens der elektrischen rotatorischen Maschinen 501 und zum Überwachen der Betriebsverhaltenssimulation vorgesehen ist. Das Simulationsprogramm umfasst hierzu einen digitalen Zwilling des Elektromotors 501. Der digitale Zwilling umfasst ein statisches, z.B. als CAD-Datei vorliegendes Modell und ein elektromechanisches Modell des Motors 501 und ermöglicht, durch Simulation des Betriebs der Maschine Simulationsmessdaten zu erzeugen, und insbesondere während der Betriebssimulation Vibrationen der Maschine zu simulieren.

Die Simulationsmessdaten, welche vorzugsweise die simulierten Vibrationsdaten umfassen, werden über die Eingang-Schnittstelle 520 der Datenanalyse-Applikation 513 zugeführt, die die Simulationsmessdaten wie die echten Messdaten 507, 509 hinsichtlich der Resonanzdrehzahlbereiche analysieren und die ermittelten, vorzugsweise kritischen Resonanzdrehzahlbereiche ausgeben und vorzugsweise an den entsprechenden Visualisierungsvorrichtungen 520 visualisieren kann.

Um Unabhängigkeit des Simulationsprogrammprodukts von den anderen Softwarepaketen zu gewährleisten ist es zweckmäßig, wenn das Simulationsprogrammprodukt die Datenanalyse-Applikation 513 umfasst.

Des Weiteren kann die Datenanalyse-Applikation 513 eine oder mehrere KPIs, die jeweilige erkannte Resonanz betreffen, ermitteln. Die Datenanalyse-Applikation 513 kann beispielsweise folgende KPIs bestimmen: die Ähnlichkeit der Übereinstimmung des Resonanzmodells mit dem echten oder simulierten Verhalten der Drehzahl-Komponente der Schwingungsamplitude der Maschine; die Anzahl der in der Resonanz verbrachten echten oder simulierten Betriebsstunden; die Amplitude der erkannten Resonanz; der Wert, der beschreibt, wie zuverlässig es bestimmt wurde, dass in dem entsprechenden Drehzahlbereich eine Resonanz vorliegt.

Die Aufgabe dieser Beschreibung besteht lediglich darin, veranschaulichende Beispiele bereitzustellen und weitere Vorteile und Besonderheiten dieser Erfindung anzugeben. Insbesondere können die im Zusammenhang mit den hier beschriebenen Verfahren offenbarten Merkmale sinnvollerweise zur Weiterbildung der hier beschriebenen Produktionsumgebung und/oder deren Simulation eingesetzt werden und umgekehrt.

## Patentansprüche

1. Verfahren zum Überwachen einer elektrischen rotatorischen Maschine (501), wobei
- einen Betrieb der Maschine betreffende Messdaten (507, 509) bereitgestellt werden (100),
- aus den Messdaten (507, 509) eine Abhängigkeit einer Drehzahl-Komponente der Schwingungsamplitude von der Drehzahl modelliert wird (104), um ein Schwingungsamplitudendrehzahlkomponente-Modell (201, 301, 401) zu erhalten,
- anhand des Schwingungsamplitudendrehzahlkomponente-Modells (201, 301, 401) der Schwingungsamplitude ein oder mehrere Drehzahlbereiche (202, 302a, 302b, 302c, 402) ermittelt werden (105), in welchen die Schwingungsamplitude ihren maximalen Wert (203, 303a, 303b, 303c, 403) erreicht,
- für die ermittelten Drehzahlbereiche (202, 302a, 302b, 302c, 402) das Verhalten der Schwingungsamplitude nach dem Schwingungsamplitudendrehzahlkomponente-Modell (201, 301, 401) mit einem Resonanzmodell verglichen wird, um festzustellen, ob in den entsprechenden Drehzahlbereichen (202, 302a, 302b, 302c, 402) eine Resonanz vorliegt,
- die ermittelten und eine Resonanz enthaltenden Drehzahlbereiche (202, 302a, 302b, 302c, 402) ausgegeben werden.

2. Verfahren nach Anspruch 1, wobei aus bekannten Resonanzdaten verschiedener elektrischer rotatorischer Maschinen ein Resonanzmodell für elektrische rotatorische Maschinen ermittelt wird.

3. Verfahren nach Anspruch 1 oder 2, wobei für einen oder mehrere der ermittelten Drehzahlbereiche (202, 302a, 302b, 302c, 402) ermittelt wird, ob der entsprechende maximale Wert (203, 303a, 303b, 303c, 403) der Schwingungsamplitude in den jeweiligen Drehzahlbereichen (202, 302a, 302b, 302c, 402) einen vorbestimmten Wert (204, 304, 404) übersteigt und der jeweilige Drehzahlbereich (202, 302a, 302b, 302c, 402) nur dann weiter berücksichtigt wird, wenn der maximale Wert (203, 303a, 303b, 303c, 403) der Schwingungsamplitude in diesem Bereich den vorbestimmten Wert (204, 304, 404) übersteigt.

4. Verfahren nach einem der Ansprüche 1 bis 3, wobei für die ermittelten und eine Resonanz enthaltenden Drehzahlbereiche (202, 302a, 302b, 302c, 402) zumindest eine, die entsprechende Resonanz kennzeichnende Charakteristik ermittelt und ausgegeben wird.

5. Verfahren nach einem der Ansprüche 1 bis 4, wobei die elektrische rotatorische Maschine (501) entsprechend den ermittelten und eine Resonanz enthaltenden Drehzahlbereichen (202, 302a, 302b, 302c, 402) gesteuert wird.

6. Verfahren nach einem der Ansprüche 1 bis 5, wobei die Messdaten (507, 509) Daten über das Drehmoment und die Schwingungsamplitude und vorzugsweise über die Drehzahl umfassen.

7. Verfahren nach einem der Ansprüche 1 bis 6, wobei, um das Schwingungsamplitudendrehzahlkomponente-Modell (201, 301, 401) zu erhalten,
- aus den Messdaten (507, 509) ein Drehmoment-Schwingungsamplitude-Modell der Maschine (501) ermittelt wird (102), welches abhängig von einem anliegenden Drehmoment eine Schwingungsamplitude modelliert,
- mittels des Drehmoment-Schwingungsamplitude-Modells aus den Messdaten (507, 509) die Abhängigkeit der Drehzahl-Komponente der Schwingungsamplitude von der Drehzahl modelliert wird.

8. Verfahren nach Anspruch 7, wobei das Modellieren der Abhängigkeit der Drehzahl-Komponente der Schwingungsamplitude von der Drehzahl mittels des Drehmoment-Schwingungsamplitude-Modells ein Ermitteln (103) der Werte der Drehzahl-Komponente und beispielsweise der Drehmoment-Komponente der Schwingungsamplitude aus den Messdaten für Datenpunkte umfasst.

9. Verfahren nach einem der Ansprüche 1 bis 8, wobei die Messdaten (507, 509) durch eine im Betrieb der Maschine (501) über einen Zeitraum durchgeführte Messung gesammelt wurden, und vorzugsweise bei der Messung zumindest zwei räumliche Komponenten der Schwingungsamplitude gemessen wurden.

10. Verfahren nach Anspruch 9, wobei die Messung mit einem an einem Gehäuse der Maschine (501) drahtlos angebrachten Messgerät (504) erfolgt.

11. Computerprogrammprodukt umfassend Befehle, die, wenn sie durch einen Computer abgearbeitet werden, diesen dazu veranlassen, ein Verfahren nach einem der Ansprüche 1 bis 10 durchzuführen.

12. System zum Überwachen einer elektrischen rotatorischen Maschine (501), wobei das System eine Eingang-Schnittstelle (520), eine Ausgang-Schnittstelle (521), einen Prozessor und einen mit dem Prozessor verbundenen Speicher umfasst, wobei der Speicher dazu eingerichtet ist, eine oder mehrere durch den Prozessor ausführbaren Komponenten zu tragen, wobei der Prozessor dazu eingerichtet ist, die eine oder mehr auf dem Speicher zur Verfügung gestellten Komponenten auszuführen, wobei
- die Eingang-Schnittstelle (520) dazu eingerichtet ist, einen Betrieb der Maschine (501) betreffende Messdaten (507, 509) zu empfangen,
- der Speicher eine Auswerte-Komponente (513) umfasst, die dazu konfiguriert ist:
* aus den Messdaten (507, 509) eine Abhängigkeit einer Drehzahl-Komponente der Schwingungsamplitude von der Drehzahl zu modellieren, um ein Schwingungsamplitudendrehzahlkomponente-Modell (201, 301, 401) zu erhalten,
* anhand des Schwingungsamplitudendrehzahlkomponente-Modells (201, 301, 401) der Schwingungsamplitude einen oder mehrere Drehzahlbereiche (202, 302a, 302b, 302c, 402) zu ermitteln, in welchen die Schwingungsamplitude ihren maximalen Wert (203, 303a, 303b, 303c, 403) erreicht,
* aus bekannten Resonanzdaten unterschiedlicher elektrischer rotatorischer Maschinen ein Resonanzmodell für elektrische rotatorische Maschinen zu ermitteln,
* für die ermittelten Drehzahlbereiche (202, 302a, 302b, 302c, 402) anhand des Drehzahl-Komponente-Modells (201, 301, 401) der Schwingungsamplitude und des Resonanzmodells festzustellen, ob in den entsprechenden Drehzahlbereichen (202, 302a, 302b, 302c, 402) eine Resonanz vorliegt,
- die Ausgang-Schnittstelle (521) dazu eingerichtet ist, die ermittelten und eine Resonanz enthaltenden Drehzahlbereiche (202, 302a, 302b, 302c, 402) auszugeben.

13. Anordnung zum Überwachen einer elektrischen rotatorischen Maschine (501), wobei die Anordnung ein der Maschine zuordbares Messgerät und ein System nach Anspruch 12 umfasst, wobei
- das Messgerät (504) dazu eingerichtet ist, einen Betrieb der Maschine (501) betreffende Messdaten (507, 509) zu sammeln und die Messdaten (507, 509) an das System (508) vorzugsweise drahtlos zu senden.

14. Antriebssystem umfassend eine elektrische rotatorische Maschine (501) und eine der Maschine zugeordnete Anordnung nach Anspruch 13.

15. Simulationsprogrammprodukt zum Simulieren eines Betriebs einer elektrischen rotatorischen Maschine (501) und zum Überwachen der Betriebssimulation, wobei
- das Simulationsprogrammprodukt einen digitalen Zwilling der Maschine (501) umfasst, welcher ein statisches und ein elektromechanisches Modell der Maschine (501) aufweist, wobei der digitale Zwilling der Maschine (501) ermöglicht, durch Simulation des Betriebs der Maschine (501) Simulationsmessdaten zu erzeugen, und insbesondere während der Betriebssimulation Vibrationen der Maschine (501) zu simulieren,
- das Simulationsprogrammprodukt eine Auswerte-Komponente (513) umfasst und dazu konfiguriert ist, die Simulationsmessdaten der Auswerte-Komponente (513) zuzuführen, wobei
- die Auswerte-Komponente (513) dazu konfiguriert ist:
* aus den Simulationsmessdaten eine Abhängigkeit einer Drehzahl-Komponente der Schwingungsamplitude von der simulierten Drehzahl zu modellieren, um ein Schwingungsamplitudendrehzahlkomponente-Modell zu erhalten,
* anhand des Schwingungsamplitudendrehzahlkomponente-Modells der Schwingungsamplitude einen oder mehrere simulierte Drehzahlbereiche zu ermitteln, in welchen die Schwingungsamplitude ihren maximalen Wert erreicht,
* aus bekannten Resonanzdaten unterschiedlicher elektrischer rotatorischer Maschinen ein Resonanzmodell für elektrische rotatorische Maschinen zu ermitteln,
* für die ermittelten simulierten Drehzahlbereiche anhand des Drehzahl-Komponente-Modells der Schwingungsamplitude und des Resonanzmodells festzustellen, ob in den entsprechenden simulierten Drehzahlbereichen eine Resonanz vorliegt,
- das Simulationsprogrammprodukt dazu konfiguriert ist, die ermittelten und eine Resonanz enthaltenden simulierten Drehzahlbereiche auszugeben.
